# EUROPEAN PATENT APPLICATION

(11) **EP 2 626 900 A2**
(43) Date of publication of application: **14.08.2013**
(21) Application number: 13152175.9
(22) Date of filing: 22.01.2013
(51) Int. Cl.: H01L 25/075, H01L 33/54, H01L 33/60

(54) **Solid-state light emitting device**

(30) Priority: 07.02.2012 CN 201210026650
(71) Applicant: Lextar Electronics (Suzhou) Corporation, 215021 Suzhou Industrial Park (CN); Lextar Electronics Corp., 300 Hsinchu (TW)
(72) Inventor: Wang, Song, Pizhou City, Jiangsu Province (CN)
(74) Representative: Viering, Jentschura & Partner

(57) **Abstract**

An exemplary embodiment of the present disclosure provides a solid-state light emitting device (100, 200). The solid-state light emitting device (100, 200) includes a stair-type bowl (110, 210), a plurality of light emitting chips (120), and an encapsulation glue (130, 230). The stair-type bowl (110, 210) includes a base (114, 214) and a ring stair structure (112, 212). The ring stair structure (112, 212) includes a plurality of ring tread surfaces (112a, 212a) and a plurality of ring riser surfaces (112b, 212b) connected to the ring tread surfaces (112a, 212a). The ring stair structure (112, 212) is connected to the base (114, 214). The base (114, 214) has a bottom surface (114a, 214a). The ring stair structure (112, 212) surrounds the bottom surface (114a, 214a) and protrudes from the bottom surface (114a, 214a). The light emitting chips (120) are respectively disposed above the ring tread surfaces (112a, 212a) and the bottom surfaces (114a, 214a). The stair-type bowl is filled with the encapsulation glue (130, 230). The encapsulation glue (130, 230) covers the light-emitting chips (120).

## Description

### BACKGROUND

### 1. Technical Field

The present disclosure relates to a light emitting device, in particular a solid-state light emitting device.

### 2. Description of Related Art

Recently, the light source of a solid-state light emitting device is usually a light-emitting diode chip, and the light-emitting diode chip has the virtue of saving electricity and low voltage driving. Therefore, the solid-state light emitting device is used in a lamp, traffic lights, and the liquid crystal display.

Generally speaking, some currently solid-state light emitting devices usually include a board and a plurality of light-emitting diode chips. The board is usually a circuit board or a metal board, and the board has a plane. The light-emitting diode chips are mounted on the plane of the board. In other words, in currently solid-state light emitting devices, a plurality of light-emitting diode chip are mounted on the same plane of the board. The arrangement way is not good for gather the lights from both the outer layer and the inner layer of the light emitting chip so that the directionality of light of the solid-state light emitting device decrease.

### SUMMARY

An exemplary embodiment of the present disclosure illustrates a solid-state light emitting device. The solid-state light emitting device includes a stair-type bowl with a plurality of light emitting chips are disposed on it. Therefore, the light emitting chips are disposed at different levels.

An exemplary embodiment of the present disclosure illustrates a solid-state light emitting device. The solid-state light emitting device includes a stair-type bowl, a plurality of light emitting chips, and an encapsulation glue. The stair-type bowl includes a base and a ring stair structure. The ring stair structure includes a plurality of ring tread surfaces and a plurality of ring riser surfaces connected to the ring tread surfaces. The ring stair structure is connected to the base. The base has a bottom surface. The ring stair structure surrounds the bottom surface and protrudes from the bottom surface. The light emitting chips are respectively disposed above the ring tread surfaces and the bottom surface. The light emitting chips on the bottom surface are electrically connected to the light emitting chips on the adjacent ring tread surface, and the light emitting chips on the one of the ring tread surfaces are electrically connected to the light emitting chip on the adjacent ring tread surface. The stair-type bowl is filled with the encapsulation glue. The encapsulation glue covers the light-emitting chips.

To sum up, in the present disclosure illustrates a solid-state light emitting device, the light emitting chips are respectively disposed above the ring tread surfaces and the bottom surface of the stair-type bowl so that the light emitting chips are respectively disposed at different levels.

In order to further understand the techniques, means and effects of the present disclosure, the following detailed descriptions and appended drawings are hereby referred, such that, through which, the purposes, features and aspects of the present disclosure can be thoroughly and concretely appreciated; however, the appended drawings are merely provided for reference and illustration, without any intention to be used for limiting the present disclosure.

### BRIEF DESCRIPTION OF THE DRAWINGS

The accompanying drawings are included to provide a further understanding of the present disclosure, and are incorporated in and constitute a part of this specification. The drawings illustrate exemplary embodiments of the present disclosure and, together with the description, serve to explain the principles of the present disclosure.

FIG. 1A depicts a vertical view diagram of a solid-state light emitting device in accordance to first exemplary embodiment of the present disclosure.

FIG. 1B depicts a section diagram of a solid-state light emitting device shown in FIG. 1A along a line 1a-1a in accordance to an exemplary embodiment of the present disclosure.

FIG. 2 depicts a section diagram of a solid-state light emitting device in accordance to second exemplary embodiment of the present disclosure.

### DESCRIPTION OF THE EXEMPLARY EMBODIMENTS

Reference will now be made in detail to the exemplary embodiments of the present disclosure, examples of which are illustrated in the accompanying drawings. Wherever possible, the same reference numbers are used in the drawings and the description to refer to the same or like parts.

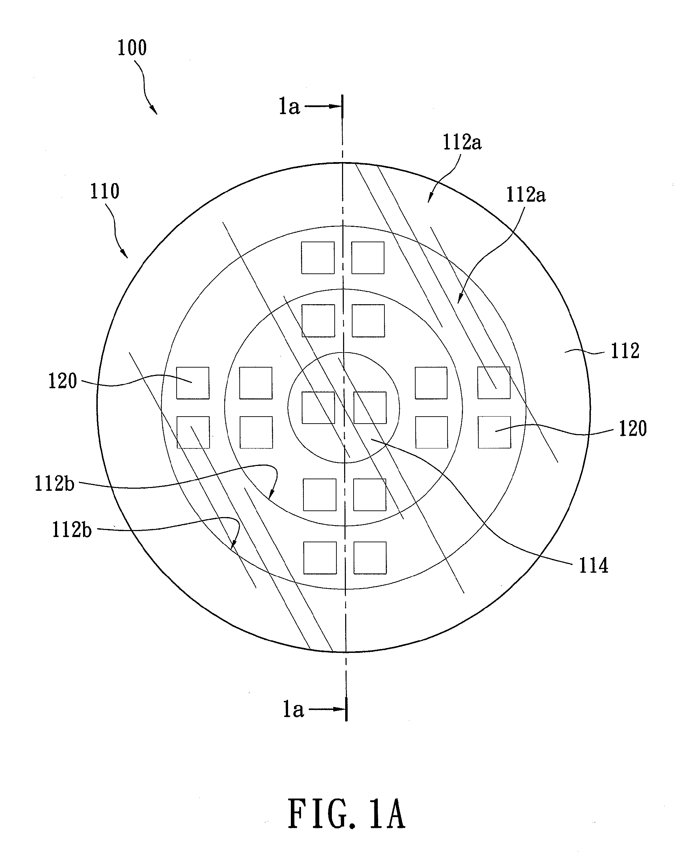

Please refer to FIG. 1A, which illustrates a vertical view diagram of a solid-state light emitting device in accordance to first exemplary embodiment of the present disclosure. The solid-state light emitting device 100 is used for a display and an illumination device, wherein the display could be a liquid crystal display or a projector, and the illumination device could be a table lamp, a status indicator light, a decoration lamp, a small night lamp, an exit light or a emergency exit light. For example, the illumination device may be a temperature indicator light of oven, a status indicator light of sound installation and other indicator light of household appliances, or the indicator light of mobile phone or computer and other electronic equipment.

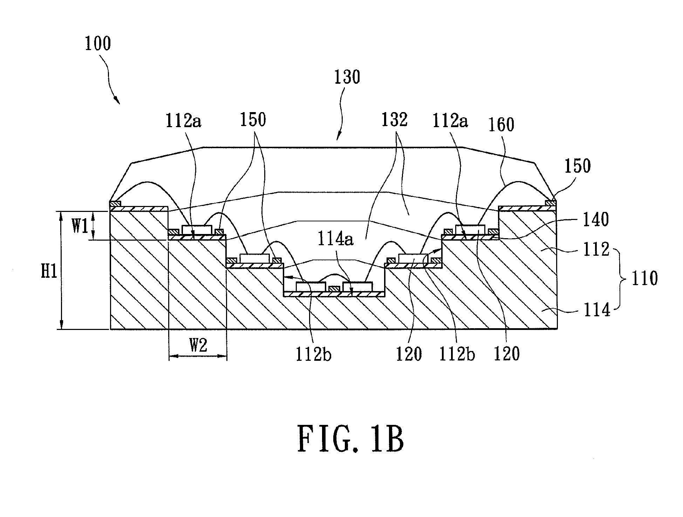

FIG. 1B illustrates a section diagram of a solid-state light emitting device shown in FIG. 1A along line 1a-1a in accordance to an exemplary embodiment of the present disclosure. Please refer to FIG. 1A and FIG. 1B. The solid-state light emitting device 100 includes a stair-type bowl 110, a plurality of light emitting chips 120, and an encapsulation glue 130. The stair-type bowl 110 includes a ring stair structure 112 and a base 114, wherein the ring stair structure 112 is disposed on the base 114 and connected to the base 114. The light emitting chips 120 are disposed on the ring stair structure 112. The encapsulation glue 130 covers the light-emitting chips 120, and the stair-type bowl 110 is filled with the encapsulation glue 130.

The material of the stair-type bowl 110 is metal, for example, aluminum or copper. The method of producing the stair-type bowl 110 includes chemical process or machining process, wherein the chemical process is such as chemical etching, and the machining process is such as impact briquetting or milling process. To impact briquetting, the method of producing the stair-type bowl 110 may impact the metal board such as copper foil once or more than once by a mold thereby forming the ring stair structure 112 and the base 114.

The base 114 includes a bottom surface 114a, and the ring stair structure 112 includes a plurality of ring tread surfaces 112a and a plurality of ring riser surfaces 112b connected to the ring tread surfaces 112a. The light emitting chips 120 are respectively disposed above the ring tread surfaces 112a and the bottom surface 114a. The ring stair structure 112 surrounds the bottom surface 114a and protrudes from the bottom surface 114a, and the ring riser surfaces 112b is connected between two adjacent ring tread surfaces 112a. Besides, the height H1 of the ring tread surfaces 112a relative to the bottom surface 114a decreases gradually from the outmost ring tread surfaces 112a to the bottom surface 114a, and the outmost ring tread surfaces 112a may not provide any light-emitting chips 120 to dispose on.

In the exemplary embodiment of the present disclosure, the width W1 of the ring riser surfaces 112b may be equivalent to one another, and the width W2 of the ring tread surfaces 112a may be equivalent to one another. However, in other exemplary embodiment of the present disclosure, at least two widths W1 of the ring riser surfaces 112b may be different from one another, namely, one width W2 of the ring tread surfaces 112a are different from another width W2 of the ring tread surfaces 112a. Hence, the present invention is not limited that the width W1 of the ring riser surfaces 112b is equivalent to one another, and the width W2 of the ring tread surfaces 112a is equivalent to one another.

The light-emitting chips 120 could be a light-emitting semiconductor component, for example, a light-emitting diode. The light emitting chips 120 are disposed on the ring tread surface 112a and the bottom surface 114a by wire bonding. Namely, the solid-state light emitting device 100 further includes a plurality of bonding wires 160 which are electrically connected to the light-emitting chips 120. The light emitting chips 120 on the bottom surface 114a are electrically connected to the light emitting chip 120 on the adjacent ring tread surface 112a, and the light emitting chips 120 on the one of the ring tread surfaces 112a are electrically connected to the light emitting chips 120 on the adjacent ring tread surfaces 112a.

The solid-state light emitting device 100 could further include a plurality of insulating layers 140 and a plurality of circuit layers 150. The insulating layers 140 are respectively disposed on the bottom surface 114a and the ring tread surfaces 112a, and the circuit layers 150 are respectively disposed on the insulating layers 140. The circuit layers 150 could be components passing the current between the light emitting chips 120. In the exemplary embodiment of the present disclosure, every light emitting chip 120 is electrically connected to one of the circuit layers 150.

In every ring tread surfaces 112a, the insulating layers 140 is placed between the circuit layers 150 and the stair-type bowl 110 so that the insulating layers 140 separate totally the circuit layers 150 from the stair-type bowl 110. Because the insulating layers 140 separate the circuit layers 150 from the stair-type bowl 110, the circuit layers 150 are not electrically connected to the stair-type bowl 110 even though the material of the stair-type bowl 110 is metal. Namely, the circuit layers 150 insulate the ring stair structure 112 electrically. Hence, the light emitting chips 120 connected to the circuit layers 150 are insulating from the ring stair structure 112 electrically.

In the exemplary embodiment of the present disclosure, the circuit layers 150 could be connected to the light emitting chips 120 on the adjacent ring tread surfaces 112a. For the same reason, the light emitting chips 120 on the one of the ring tread surfaces 112a are electrically connected to the light emitting chips 120 on the adjacent ring tread surfaces 112a thought the bonding wires 160. Besides, two of the light emitting chips 120 could be connected to each other in series or in parallel.

The encapsulation glue 130 could consist of multiple encapsulation materials 132, and the stair-type bowl 110 is filled with the encapsulation materials 132 layer by layer. Every encapsulation material 132 covers at least one ring riser surfaces 112b and at least one ring tread surface 112a. The outmost encapsulation materials 132 could protrude from the outmost layer of the ring tread surface 112a.

The encapsulation materials 132 could be a thermosetting resin. The refractive indexes of the encapsulation materials 132 could be different, and / or the phosphors are added in the encapsulation materials 132 are different. Namely, the refractive index of one of the encapsulation materials 132 could be different from the refractive index of another encapsulation material 132, or the phosphors of one of the encapsulation materials 132 could be different from the phosphors of another encapsulation material 132. Hence, the difference of the refractive index or the variety phosphors of the encapsulation materials 132 could produce the variety light effects.

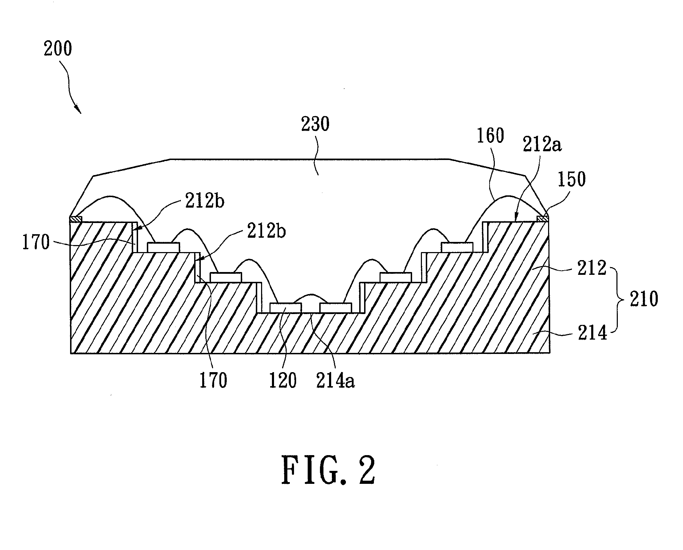

Please refer to FIG. 2, which illustrates a section diagram of a solid-state light emitting device in accordance to second exemplary embodiment of the present disclosure. The structure of the solid-state light emitting device 200 in accordance to second exemplary embodiment and the solid-state light emitting device 100 of in accordance to first exemplary embodiment are similar. For example, the solid-state light emitting device 200 includes a stair-type bowl 210, a plurality of light emitting chips 120, and an encapsulation glue 230. The light emitting chips 120 are disposed on the ring stair-type bowl 210. The encapsulation glue 230 covers the light-emitting chips 120, and the stair-type bowl 210 is filled with the encapsulation glue 230.

Accordingly, the ring stair-type bowl 210 includes a ring stair structure 212 and a base 214 connected to the ring stair structure 212. Same as the first exemplary embodiment, the ring stair structure 212 includes a plurality of ring tread surfaces 212a and a plurality of ring riser surfaces 212b connected to the ring tread surfaces 212a. The light emitting chips 120 are also respectively disposed above the ring tread surfaces 212a and the bottom surface 214a by wire bonding. Therefore, the solid-state light emitting device 200 also includes a plurality of bonding wires 160 electrically connected to the light emitting chips 120.

However, there are some differences between the first exemplary embodiment and the second exemplary embodiment. Specifically, the stair-type bowl 210 consists of non-metal materials, such as plastics or ceramics, wherein the non-metal materials are insulators so that the stair-type bowl 210 is insulating and no conductive. Therefore, the light emitting chips 120 do not short-circuit through the stair-type bowl 210. Namely, the stair-type bowl 210 connected to the light emitting chips 120 are insulating from the ring stair structure 112 electrically. Comparing with the first exemplary embodiment, the solid-state light emitting device 200 may not include insulating layers 140, and the light emitting chips 120 could be disposed on the ring tread surfaces 212a and the bottom surface 214a directly.

Besides, the solid-state light emitting device 200 could further include the circuit layers 150. In the exemplary embodiment of the present disclosure, the circuit layers 150 could only be disposed on the outmost ring tread surfaces 212a, and could not disposed on the bottom surface 214a or other ring tread surfaces 212a. Although the light emitting chips 120 could not disposed on the outmost ring tread surfaces 212a, the light emitting chips 120 could be electrically connected to the circuit layers 150 by using the bonding wires 160 as illustrated in FIG. 2. However, the circuit layers 150 shown in FIG. 2 are merely provided for reference and illustration. The present invention is not limited that the amount and configuration of the circuit layers 150.

As distinguished from the solid-state light emitting device 100, the encapsulation glue 230 consists of one layer of the encapsulation material, wherein the encapsulation material could be the encapsulation material 132 in the first exemplary embodiment. Besides, the solid-state light emitting device 200 could further include a plurality of reflective layers 170. The reflective layers 170 respectively cover the ring riser surfaces 212b. The reflective layer 170 could be a film formed by reflective material. For example, the said reflective materials are glass specks, paints (especially white paints), polymer composites, or metal films. The reflective layers 170 could reflect and gather the lights of the light emitting chips 120 so that the brightness of the solid-state light emitting device 200 could gain.

In summary, in the present disclosure, the light emitting chips are respectively disposed above the ring tread surfaces and the bottom surface of the stair-type bowl so that the light emitting chips are respectively disposed at different levels. Besides, the lights of the light emitting chips disposed at different levels could be gathered so that the directionality of light of the solid-state light emitting device increases.

The above-mentioned descriptions represent merely the exemplary embodiment of the present disclosure, without any intention to limit the scope of the present disclosure thereto. Various equivalent changes, alternations or modifications based on the claims of present disclosure are all consequently viewed as being embraced by the scope of the present disclosure.

## Claims

1. A solid-state light emitting device (100, 200) comprising:
a stair-type bowl (110, 210) comprising: a base (114, 214) having a bottom surface (114a, 214a); and
a ring stair structure (112, 212)comprising a plurality of ring tread surfaces (112a, 212a) and a plurality of ring riser surfaces (112b, 212b) connected to the ring tread surfaces (112a, 212a), wherein the ring stair structure (112, 212) is connected to the base (114, 214), the base (114, 214) has a bottom surface (114a, 214a), the ring stair structure (112, 212) surrounds the bottom surface (114a, 214a) and protrudes from the bottom surface (114a, 214a);
a plurality of light emitting chips (120) are respectively disposed above the ring tread surfaces (112a, 212a) and the bottom surface (114a, 214a), wherein the light emitting chips (120) on the bottom surface (114a, 214a) are electrically connected to the light emitting chips (120) on the adjacent ring tread surface (112a, 212a), and the light emitting chips (120) on the one of the ring tread surfaces (112a, 212a) are electrically connected to the light emitting chip (120) on the adjacent ring tread surfaces (112a, 212a); and
an encapsulation glue (130, 230) covering the light-emitting chips (120), wherein the stair-type bowl (110, 210) is filled with the encapsulation glue (130, 230).

2. The solid-state light emitting device (100, 200) according to claim 1, wherein the heights (H1) of the ring tread surfaces (112a, 212a) relative to the bottom surface (114a, 214a) decrease gradually from the outmost ring tread surfaces (112a, 212a) to the bottom surface (114a, 214a).

3. The solid-state light emitting device (100, 200) according to claim 2, wherein the encapsulation glue (130, 230) consists of at least one encapsulation material (132).

4. The solid-state light emitting device (100, 200) according to claim 3, wherein the every one encapsulation material (132) covers at least one ring tread surface (112a, 212a) and at least one ring riser surface (112b, 212b).

5. The solid-state light emitting device (100, 200) according to claim 4, wherein the refractive indexes of at least two encapsulation materials (132) are different or the phosphors of at least two encapsulation materials (132) are different.

6. The solid-state light emitting device (100, 200) according to claim 1, wherein the material of the stair-type bowl (110, 210) is non-metal.

7. The solid-state light emitting device (100, 200) according to claim 1, wherein the material of the stair-type bowl (110, 210) is metal.

8. The solid-state light emitting device (100, 200) according to claim 7 further comprising a plurality of insulating layers (140), wherein the insulating layers (140) are respectively disposed on the bottom surface (114a, 214a) and the ring tread surfaces (112a, 212a), and the light emitting chips (120) are disposed on the insulating layers (140).

9. The solid-state light emitting device (100, 200) according to claim 8 further comprising a plurality of circuit layers (150), wherein the circuit layers (150) are respectively disposed on the insulating layers (140) and insulate the stair-type bowl electrically, and every light emitting chip (120) electrically connected to the one of the circuit layer (150).

10. The solid-state light emitting device (100, 200) according to any one of the claim 1 to 9 further comprising a plurality of reflective layers (170) covering the ring riser surfaces (112b, 212b).

11. The solid-state light emitting device (100, 200) according to any one of the claim 1 to 9, wherein the light emitting chips (120) are disposed on the ring tread surfaces (112a, 212a) and the bottom surface (114a, 214a) by wire bonding.

12. The solid-state light emitting device (100, 200) according to any one of the claim 1 to 9, wherein the light emitting chips (120) do not be disposed on the outmost ring tread surfaces (112a, 212a).
